# EUROPEAN PATENT APPLICATION

(11) **EP 4 629 222 A1**
(43) Date of publication of application: **08.10.2025**
(21) Application number: 22967945.1
(22) Date of filing: 08.12.2022
(51) Int. Cl.: G09G 3/20

(54) **PANEL INTERFACE**

(71) Applicant: LG Electronics Inc., Yeongdeungpo-gu Seoul 07336 (KR)
(72) Inventor: KO, Taehwan, Seoul 06772 (KR)
(74) Representative: Schornack, Oliver
(86) International application number: PCT/KR2022/019953
(87) International publication number: WO 2024/122687

(57) **Abstract**

The present invention relates to a panel interface for transmitting a signal from a main control board to a source driver IC. In order to minimize signal performance attenuation occurring when ground traces arranged between signal traces are removed, the panel interface according to the present invention comprises a printed circuit board having a plurality of signal traces, wherein at least one from among the plurality of signal traces can be used as the ground.

## Description

### [Technical Field]

The present disclosure relates to a panel interface. The present disclosure relates to a structure of a printed circuit board (PCB) of the panel interface.

### [Background Art]

As display resolution increases, an amount of data transmitted is rapidly increasing. Accordingly, a high-speed panel interface suitable for high resolution is required. In addition, as a screen size of a display device increases, a distance between an image processing board and a display driver IC for driving a panel is increasing. As the distance increases, a problem of signal attenuation becomes severe. Accordingly, a panel interface that can handle the increased amount of data and minimize loss due to signal attenuation is required.

In addition, the number of solder balls is reduced every year for a miniaturized SoC package, and a method to cope with the increasing integration of the PCB pattern is required.

### [Disclosure]

### [Technical Problem]

The present disclosure provides a trace design structure of a printed circuit board that enables miniaturization of a panel interface.

The present disclosure seeks to minimize signal performance attenuation that occurs when ground traces placed between signal traces are removed.

### [Technical Solution]

A panel interface according to an embodiment of the present disclosure includes a printed circuit board having a plurality of signal traces, and at least one of the plurality of signal traces can be used as a ground.

A signal trace used as the ground can be impedance matched with an adjacent signal trace.

A signal trace used as the ground can be determined based on a signal performance of a transmission line formed by each signal trace.

The signal performance can be determined based on a length of a transmission line from a main control board to a source driver IC formed by each signal trace.

A signal trace adjacent to a predetermined number of signal traces determined in order of the length of the transmission line from the main control board to the source driver IC can be used as the ground.

A signal trace used as the ground can be determined based on a gap with an adjacent signal trace.

One of two signal traces having the shortest gap with an adjacent signal trace among the plurality of signal traces can be used as the ground.

One of the plurality of signal traces can be placed between the signal traces, and another of the plurality of signal traces can be placed between the signal trace and the ground trace.

The signal trace used as the ground can be connected to the ground of the main control board.

The signal trace used as the ground can be connected to a switch connected to the ground of the main control board.

### [Advantageous Effects]

According to an embodiment of the present disclosure, since at least one of the plurality of signal traces is used as a ground, a ground trace can be removed, and accordingly, space can be secured equivalent to an area occupied by the removed ground trace, so that the printed circuit board can be miniaturized.

According to an embodiment of the present disclosure, even if the ground trace is removed, since at least one signal trace is used as the ground, signal attenuation between signal traces can be compensated, so that there is an advantage of minimizing the degradation of signal performance.

According to an embodiment of the present disclosure, since the signal trace to be used as the ground is determined according to signal performance, there is an advantage of maximizing the effect of compensating for signal attenuation.

### [Description of Drawings]

FIG. 1 is a drawing illustrating a part of a configuration of a display device according to an embodiment of the present disclosure.
FIG. 2 is an exemplary drawing for explaining a panel interface provided in a display device.
FIG. 3 is a drawing illustrating a part of a printed circuit board of a conventional panel interface.
FIG. 4 is a drawing illustrating a part of a printed circuit board of a conventional panel interface with a ground trace removed.
FIG. 5 is a drawing illustrating a part of a printed circuit board of a panel interface according to an embodiment of the present disclosure.
FIG. 6 is a drawing for explaining a case where at least one signal trace is used as a ground in a panel interface according to an embodiment of the present disclosure.
FIG. 7 shows measured jitter for each case where a ground ball exists, where a ground ball is removed, and where an unused signal trace is used as the ground when a ground ball is removed.

### [Best Mode]

Hereinafter, the present invention will be described in more detail with reference to the drawings.

Terms including ordinal numbers such as first, second, etc. may be used to describe various components, but the components are not limited by the terms. The terms are used only for the purpose of distinguishing one component from another.

The singular expression includes the plural expression unless the context clearly indicates otherwise.

In this application, the terms "include" or "have" are intended to specify the presence of a feature, number, step, operation, component, part, or combination thereof described in the specification, but should be understood as not excluding in advance the possibility of the presence or addition of one or more other features, numbers, steps, operations, components, parts, or combinations thereof.

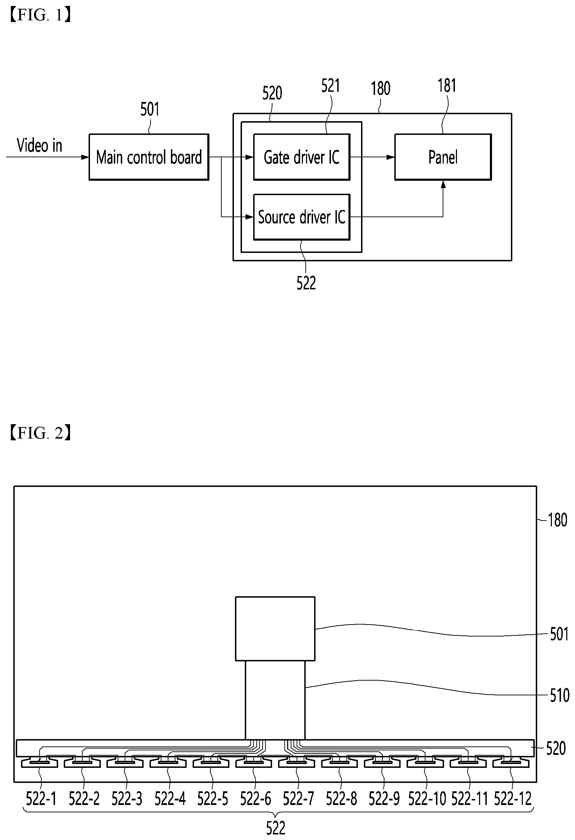

FIG. 1 is a drawing illustrating a part of a configuration of a display device according to an embodiment of the present disclosure.

The display device is an electronic device that displays an image, and may correspond to a TV, a monitor, a tablet PC, a mobile terminal, etc.

The display device may include a display 180 that displays the image and a main control board 501 that controls the display 180. However, the configuration illustrated in FIG. 1 illustrates only some of the configurations necessary for explaining the present disclosure, and it is natural that the display device 100 includes other configurations in addition to the configuration illustrated in FIG. 1.

When an image signal is input, the main control board 501 may perform signal processing on the input image signal to control the display 180 to output the image. That is, the main control board 501 may control the display 180. The main control board 501 may be implemented as a system on chip (SoC).

The main control board 501 may output a control signal to a display driver IC 520 through a timing controller (not illustrated). The timing controller (not shown) of the display device according to the embodiment of the present disclosure may be separately provided between the main control board 501 and the data driver IC 520, or may be provided inside the main control board 501. That is, the timing controller (not shown) may be a configuration included in the main control board 501. The present disclosure assumes that the timing controller (not shown) is included in the main control board 501.

The display 180 may include a panel 181 and the data driver IC 520 that supplies a scanning signal and an image signal to the panel 181.

The type of panel 181 may vary. For example, the display 180 may include one of a liquid crystal display panel (LCD panel), an organic light-emitting panel (OLED panel), and an inorganic light-emitting panel (LED panel).

In the panel 181, a plurality of gate lines and data lines are arranged to intersect, and pixels are defined in intersecting areas.

The display driver IC 520 can supply scanning signals and image signals so that the pixels defined in the panel 181 can implement various colors.

The display driver IC 520 is a semiconductor that drives the pixels that make up the screen. Each pixel is composed of sub-pixels of R, G, and B, or sub-pixels of R, G, B, and W, and the display driver IC 520 controls the transistors of each sub-pixel. The display driver IC 520 can express various colors by controlling the output through the transistors of the sub-pixels.

The display driver IC 520 can be largely composed of a gate driver IC 521 and a source driver IC 522. The gate driver IC 521 can turn sub-pixels on or off through an on/off driving signal. The source driver IC 522 can control the image signal for implementing the color of the pixel.

The display driver IC 520 includes a plurality of gate driver ICs 521 and a plurality of data driver ICs (523), and the display driver IC 520 can be arranged at the end of the panel 181. In particular, the plurality of gate driver ICs 521 can be arranged in the vertical direction of the panel 181, and the plurality of source driver ICs 522 can be arranged in the horizontal direction of the panel 181.

The display device can include a panel interface 510 (see FIG. 2) connecting the main control board 501 and the display driver IC 520, and this will be described with reference to FIG. 2.

FIG. 2 is an example drawing for explaining a panel interface provided in the display device.

The panel interface 510 can transmit a control signal output from the main control board 501 to the display driver IC 520. That is, the panel interface 510 may be a signal transmission medium from the main control board 501 to the display driver IC 520. The panel interface 510 may connect between the main control board 501 and the display driver IC 520.

In particular, FIG. 2 illustrates the panel interface 510 connecting the main control board 501 and the source driver IC 522. FIG. 2 may be a view of the cover (not shown) covering the back of the display 180 separated. Referring to the example of FIG. 2, the main control board 501 may be arranged in the center of the display 180, and the source driver IC 522 may be arranged below.

The source driver IC 522 may be arranged in multiple numbers, and may be arranged horizontally at the bottom of the display 180 as illustrated in FIG. 2. For example, a plurality of source driver ICs 522 may include first to twelfth source driver ICs (522-1 to 522-12), but the number of source driver ICs 522 is merely exemplary and is not limited thereto.

According to an embodiment, a plurality of source driver ICs 522 may be connected to a source PCB 520, and a panel interface 510 may be arranged between the main control board 501 and the source PCB 520 to connect the main control board 501 and the source driver IC 522.

The panel interface 510 may include a printed circuit board (PCB).

A signal trace, a ground trace, etc. may be formed on the printed circuit board.

The trace may be composed of a flat or narrow copper foil remaining after etching on the printed circuit board, etc.

The signal trace may be a conductive track that electrically connects components or allows current to flow with little resistance.

The ground trace may be a trace connected to a ground point, etc. For example, the ground trace may be routed to a ground plane of another layer via a solder ball, etc.

In the printed circuit board of the conventional panel interface 510, the ground trace is placed between the signal traces. That is, in the printed circuit board of the conventional panel interface 510, the signal traces and the ground traces are placed alternately.

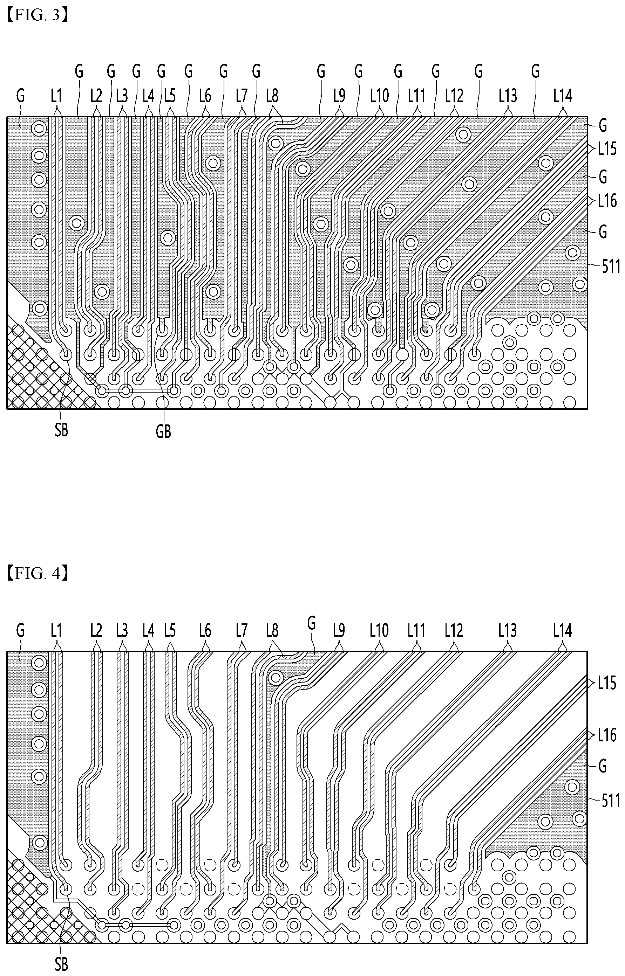

FIG. 3 is a drawing showing a part of a printed circuit board of a conventional panel interface.

The panel interface 510 includes a printed circuit board 511, and the printed circuit board 511 may include a plurality of signal traces L1 to L16 and a plurality of ground traces G.

Each of the plurality of signal traces L1 to L16 may be formed as a trace pair for transmitting a differential signal.

In addition, it can be confirmed that each of the plurality of signal traces L1 to L16 is arranged between the plurality of ground traces G. In this case, each of the plurality of signal traces L1 to L16 is designed to have an impedance matching with the adjacently arranged ground trace. This arrangement is intended to minimize crosstalk between the signal traces.

However, as shown in FIG. 3, it can be confirmed that at least one solder ball is formed at the end of each of the plurality of signal traces L1 to L16 and each of the ground traces G. A solder ball is a component that provides contact between a chip package and a printed circuit board, between chip packages, or between printed circuit boards. For convenience of explanation, a solder ball connected to a signal trace is called a signal ball SB, and a solder ball connected to a ground trace is called a ground ball (GB), but this is only an example and should not be construed as being limited thereto.

The conventional panel interface 510 has a limitation in miniaturization because a large number of signal balls SB and a large number of ground balls GB are formed on the printed circuit board 511. Accordingly, a method of removing the ground trace G and the ground ball can be considered, but in this case, there is a problem that crosstalk occurs between the signal traces and the signal performance is degraded.

Therefore, the present disclosure provides a panel interface that minimizes the number of ground traces G and ground balls while supplementing the signal performance attenuation.

First, FIG. 4 is a drawing showing a part of a printed circuit board of a conventional panel interface with the ground traces removed.

As illustrated in FIG. 4, the printed circuit board 511 of the panel interface 510 can be designed so that the ground traces between signal traces L1 to L16 and the ground balls (illustrated by dotted lines) connected to them are removed. Accordingly, it can be confirmed that the space occupied by the ground traces and the ground balls connected to the ends thereof is secured.

Therefore, the printed circuit board 511 of the panel interface 510 according to the embodiment of the present disclosure can be designed so that the signal traces and the signal balls SB connected to the ends thereof are arranged in the space secured by the above-described method.

According to one embodiment, the printed circuit board 511 of the panel interface 510 may be designed such that all ground traces between signal traces L1 to L16 are removed.

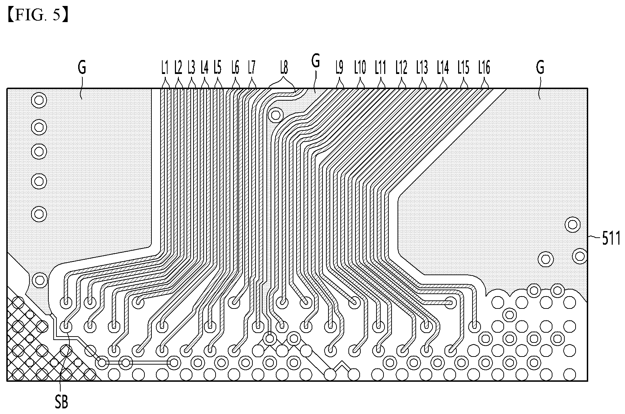

According to another embodiment, the printed circuit board 511 of the panel interface 510 may be designed such that only some ground traces between signal traces L1 to L16 are removed. This case is described in detail with reference to FIG. 5.

FIG. 5 is a drawing illustrating a portion of a printed circuit board of a panel interface according to an embodiment of the present disclosure.

As illustrated in FIG. 5, the printed circuit board 511 may have a plurality of signal traces L1 to L16, and one of the plurality of signal traces L1 to L16 may be arranged between the signal traces, and another of the plurality of signal traces L1 to L16 may be arranged between the signal trace and the ground trace.

Referring to the example of FIG. 5, it can be confirmed that the first, eighth, ninth, and 16th signal traces L1, L8, L9, and L16 of the printed circuit board 511 are arranged between the signal trace and the ground trace G, and the second to seventh, tenth to fifteenth signal traces L2 to L7, L10 to L15 are arranged between the signal traces.

Specifically, the printed circuit board 511 can be designed so that a ground trace is removed between a first signal trace L1 and a second signal trace L2, a ground trace is removed between the second signal trace L2 and a third signal trace L3, a ground trace is removed between the third signal trace L3 and a fourth signal trace L4, a ground trace is removed between the fourth signal trace L4 and a fifth signal trace L5, a ground trace is removed between the fifth signal trace L5 and a sixth signal trace L6, a ground trace is removed between the sixth signal trace L6 and a seventh signal trace L7, a ground trace is removed between the seventh signal trace L7 and an eighth signal trace L8, a ground trace is removed between the ninth signal trace L9 and a tenth signal trace L10, a ground trace is removed between the tenth signal trace L10 and an eleventh signal trace L11, and a ground trace is removed between the eleventh signal trace L11 and the 12th signal trace L12, a ground trace is removed between the 12th signal trace L12 and the 13th signal trace L13, a ground trace is removed between the 13th signal trace L13 and the 14th signal trace L14, a ground trace is removed between the 14th signal trace L14 and the 15th signal trace L15, a ground trace is removed between the 15th signal trace L15 and the 16th signal trace L16, and a ground trace G is formed between the 8th signal trace L8 and the 9th signal trace L9.

In this way, some signal traces L1, L8, L9, and L16 may be arranged adjacent to the ground trace G, which may be to compensate for signal performance attenuation.

That is, the printed circuit board 511 of the panel interface 510 according to the embodiment of the present disclosure may be formed such that among the plurality of signal traces L1 to L16, the signal traces L8, L9 whose signal performance is less than a preset reference value are adjacent to the ground trace G.

At this time, the signal performance may be determined based on the length of the transmission line. That is, the signal performance may be determined based on the length of the transmission line from the main control board 501 to the source driver IC 522, which each signal trace constitutes.

As a specific example, 12 of the first to 16th signal traces L1 to L16 each constitute a transmission line between the main control board 501 and one of the first to twelfth source driver ICs (522-1 to 522-12). At this time, the longest transmission line may be the transmission line between the main control board 501 and the first source driver IC 522-1 and the transmission line between the main control board 501 and the twelfth source driver IC 522-12. The second longest transmission line may be the transmission line between the main control board 501 and the second source driver IC 522-2 and the transmission line between the main control board 501 and the eleventh source driver IC 522-11...., The shortest transmission line may be the transmission line between the main control board 501 and the sixth source driver IC 522-6 and the transmission line between the main control board 501 and the seventh source driver IC 522-7.

In general, the longer the length of the transmission line, the more severe the signal performance degradation. Therefore, the signal performance of the signal trace connecting the main control board 501 and the first source driver IC 522-1 and the signal trace connecting the main control board 501 and the twelfth source driver IC 522-12 may be the lowest. The signal performance of the signal trace connecting the main control board 501 and the second source driver IC 522-2 and the signal trace connecting the main control board 501 and the eleventh source driver IC 522-11 may be the second lowest.... The signal performance of the signal trace connecting the main control board 501 and the sixth source driver IC 522-6 and the signal trace connecting the main control board 501 and the seventh source driver IC 522-7 may be the highest.

For example, if the signal trace connecting the main control board 501 and the first source driver IC 522-1 is the eighth signal trace L8, and the signal trace connecting the main control board 501 and the twelfth source driver IC 522-12 is the ninth signal trace (L9), as illustrated in FIG. 5, the eighth and ninth signal traces L8, L9 may be formed adjacent to the ground trace G.

Meanwhile, as another method for compensating for signal performance attenuation, the present disclosure proposes a method of using at least one signal trace as a ground. That is, in the printed circuit board 511 of the panel interface 510 according to the embodiment of the present disclosure, at least one of a plurality of signal traces L1 to L16 may be used as the ground. Depending on the model of the display device in which the panel interface 510 is provided, all of the plurality of signal traces may constitute transmission lines, or only some of them may constitute transmission lines. The present disclosure intends to use the traces that do not constitute transmission lines as the ground when only some of the plurality of signal traces constitute transmission lines and the rest do not constitute transmission lines. The traces that do not constitute transmission lines may be unused traces.

That is, the panel interface 510 according to the embodiment of the present disclosure can use at least one of the plurality of signal traces as the ground. In particular, the panel interface 510 can use an unused trace as the ground.

According to the embodiment of the present disclosure, the signal trace used as the ground can be determined based on the signal performance of the transmission line formed by each signal trace. For example, the printed circuit board 511 of the panel interface 510 can obtain at least one trace with low signal performance, and determine a trace adjacent to the obtained trace as a trace used as the ground.

For example, in the case where there are four unused traces, signal traces adjacent to a predetermined number (for example, four) of signal traces determined in the order of poor signal performance, that is, in the order of long transmission line lengths from the main control board 501 to the source driver IC 522, can be used as the ground.

Referring to the example of FIG. 2, the four signal traces determined to have bad signal performances may be signal traces connecting the main control board 501 and the first, second, 11th, and 12th source driver ICs 522-1, 522-2, 522-11, 522-12, respectively, and may be the sixth, eighth, ninth, and eleventh signal traces L6, L8, L9, L11. In this case, the printed circuit board 511 may use the signal traces adjacent to the sixth, eighth, ninth, and eleventh signal traces L6, L8, L9, L11, i.e., the fifth, seventh, tenth, and twelfth signal traces L5, L7, L10, L12, as grounds.

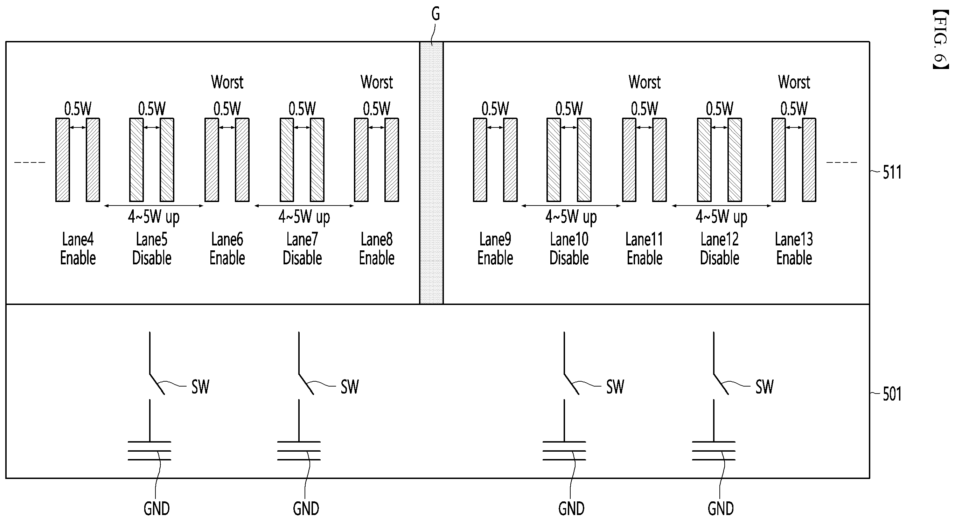

FIG. 6 is a drawing for explaining the use of at least one signal trace as the ground in a panel interface according to an embodiment of the present disclosure.

As in the example of FIG. 6, if the predetermined number of signal traces determined in order of low signal performance are the 6th, 8th, 9th, and 11th signal traces L6, L8, L9, L11, the 5th, 7th, 10th, and 12th signal traces L5, L7, L10, L12 adjacent to them can be used as grounds.

Meanwhile, if the number of unused traces is insufficient, a ground trace G may be formed between signal traces L8, L9 with low signal performance on the printed circuit board 511.

The unused trace used as the ground can be connected to the ground GND of the main control board 501 and serve as the ground.

Meanwhile, as described above, depending on the model of the display device, a plurality of signal traces may all constitute a transmission line, in which case there are no unused traces. That is, depending on the model of the display device, some signal traces L5, L7, L10, L12 may be used as the ground or may not be used. Therefore, according to one embodiment, some signal traces L5, L7, L10, L12 of the printed circuit board 511 may be connected to the ground GND of the main control board 501 through a switch SW. That is, the signal traces L5, L7, L10, L12 used as ground may be connected to the switch SW connected to the ground GND of the main control board 501. If the model of the display device is a model in which all of a plurality of signal traces must form a transmission line, the switch SW of the main control board 501 is turned off, and thus the signal traces L5, L7, L10, L12 can be used as signal traces through which control signals are transmitted. Conversely, if the model of the display device is a model in which only some of the plurality of signal traces must form a transmission line, the switch SW of the main control board 501 is turned on, and thus the signal traces L5, L7, L10, L12 can be used as ground traces.

In this way, when some signal traces that do not constitute a transmission line are used as grounds, the signal traces used as grounds can be impedance matched with adjacent signal traces. Accordingly, according to the present disclosure, the role of the removed ground trace G between signal traces can be replaced by an unused trace.

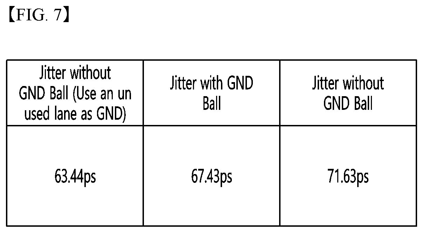

FIG. 7 shows measured jitter for each case where a ground ball exists, where a ground ball is removed, and where an unused signal trace is used as the ground when a ground ball is removed.

Jitter indicates that the temporal position of a transmitted pulse fluctuates before and after a regular point in time. In other words, the larger the jitter, the worse the signal performance, and the smaller the jitter, the better the signal performance.

Referring to FIG. 7, the jitter when a ground ball exists (Jitter with GND Ball) represents the jitter of the conventional panel interface, that is, the case with ground trace G and ground ball GB, and it was measured as 67.43ps.

However, the jitter when only the ground trace G and ground ball GB are deleted for miniaturization of the panel interface (Jitter without GND Ball) was measured as 73.63ps. In other words, it can be confirmed that the signal performance deteriorates simply by removing the ground trace G and ground ball GB.

Accordingly, as in the present disclosure, the jitter when the ground trace G and ground ball GB are removed and an unused signal trace is used as a ground (Jitter without GND Ball (Use an unused lane as GND)) is 63.44ps, and it can be confirmed that the signal performance improves compared to when a ground ball exists.

That is, according to the present disclosure, when the ground trace G and ground ball (GB) are deleted and the unused signal trace is used as a ground, there is an advantage of achieving miniaturization of the printed circuit board while minimizing signal performance attenuation.

Meanwhile, according to another embodiment of the present disclosure, the signal trace used as a ground in the panel interface 510 may be determined based on the gap between the signal traces instead of the signal performance.

That is, since the crosstalk between the signal traces becomes more severe as the signal traces are closer, the signal trace used as a ground may be determined based on the gap with the adjacent signal trace.

Specifically, among the plurality of signal traces, one of the two signal traces having the shortest gaps with adjacent signal traces can be used as the ground. For example, the gaps with the adjacent signal traces can include a first gap between a first signal trace L1 and a second signal trace L2, a second gap between a second signal trace L2 and a third signal trace L3, a third gap between a third signal trace L3 and a fourth signal trace L4, ..., a fifteenth gap between a fifteenth signal trace L15 and a sixteenth signal trace L16. One of the two signal traces having the shortest gaps among the first to fifteenth gaps can be used as a ground. For example, if the first gap among the first to fifteenth gaps is the shortest, one of the first signal trace L1 and the second signal trace L2 can be determined to be used as a ground.

Because as the signal attenuation can be severe as the gap is the narrowest, this has the advantage of being able to compensate for signal attenuation by determining any one of the signal traces with the shortest gap is used as the ground.

Meanwhile, this can be applied when the gap between the first to 16 signal traces L1 to L16 is not constant.

The above description is merely an example of the technical idea of the present disclosure, and those with ordinary knowledge in the technical field to which the present disclosure belongs may make various modifications and variations without departing from the essential characteristics of the present disclosure.

Therefore, the embodiments disclosed in the present disclosure are not intended to limit the technical idea of the present disclosure but to explain it, and the scope of the technical idea of the present disclosure is not limited by these embodiments.

The protection scope of the present disclosure should be interpreted by the claims below, and all technical ideas within the equivalent scope should be interpreted as being included in the scope of the rights of the present disclosure.

## Claims

1. A panel interface for transmitting signals from a main control board to a source driver IC,
a printed circuit board having a plurality of signal traces, and
at least one of the plurality of signal traces is used as a ground.

2. The panel interface of claim 1, wherein the signal trace used as the ground is impedance matched to an adjacent signal trace.

3. The panel interface of claim 1, wherein the signal trace used as the ground is determined based on a signal performance of a transmission line formed by each signal trace.

4. The panel interface of claim 3, wherein the signal performance is determined based on a length of the transmission line from the main control board to the source driver IC, which constitutes each signal trace.

5. The panel interface of claim 4, wherein a signal trace adjacent to a predetermined number of signal traces, which are determined in order of the length of the transmission line from the main control board to the source drive IC, is used as the ground.

6. The panel interface of claim 1, wherein the signal trace used as the ground is determined based on a gap with adjacent signal traces.

7. The panel interface of claim 6, wherein one of two signal traces with shortest gap to the adjacent signal traces among the plurality of signal traces is used as the ground.

8. The panel interface of claim 1, wherein one of the plurality of signal traces is placed between the signal traces, and another of the plurality of signal traces is placed between the signal trace and a ground trace.

9. The panel interface of claim 1, wherein the signal trace used as the ground is connected to a ground of the main control board.

10. The panel interface of claim 9, wherein a signal trace used as the ground is connected to a switch connected to the ground of the main control board.
